**Europäisches Patentamt**

**European Patent Office**

**Office européen des brevets**

(19)

(11) Veröffentlichungsnummer : **0 186 091**
**B1**

(12) # EUROPÄISCHE PATENTSCHRIFT

(45) Veröffentlichungstag der Patentschrift :
02.03.88

(51) Int. Cl.⁴ : **G 03 C 1/68**

(21) Anmeldenummer : **85116040.8**

(22) Anmeldetag : **16.12.85**

(54) **Trockenfilmresist und Verfahren zur Herstellung von Resistmustern.**

(30) Priorität : **24.12.84 DE 3447357**

(43) Veröffentlichungstag der Anmeldung :
**02.07.86 Patentblatt 86/27**

(45) Bekanntmachung des Hinweises auf die Patenterteilung : **02.03.88 Patentblatt 88/09**

(84) Benannte Vertragsstaaten :
**BE CH DE FR GB IT LI NL**

(56) Entgegenhaltungen :
**DE-A- 2 557 408**
**FR-A- 2 361 681**
**GB-A- 2 070 634**
**GB-A- 2 091 278**
**US-A- 4 228 232**
**US-A- 4 296 196**

(73) Patentinhaber : **BASF Aktiengesellschaft**
**Carl-Bosch-Strasse 38**
**D-6700 Ludwigshafen (DE)**

(72) Erfinder : **Elzer, Albert, Dr.**
**Pappelstrasse 4**
**D-6701 Otterstadt (DE)**
Erfinder : **Schornick, Gunnar, Dr.**
**Konrad-Adenauer-Strasse 8**
**D-6719 Neuleiningen (DE)**
Erfinder : **Sanner, Axel, Dr.**
**Lorscher Ring 2c**
**D-6710 Frankenthal (DE)**

EP 0 186 091 B1

**Beschreibung**

Die Erfindung betrifft einen Trockenfilmresist mit einer auf einem dimensionsstabilen, temporären Träger aufgebrachten, festen, wäßrig — insbesondere wäßrig-alkalisch — entwickelbaren, photopolymerisierbaren Resistschicht sowie gegebenenfalls einer abziehbaren Deckfolie auf dieser Resistschicht. Die Erfindung betrifft des weiteren ein Verfahren zur Herstellung von Resistmustern auf einem Substrat, bei dem auf das Substrat eine photopolymerisierbare, in wäßrigen — insbesondere wäßrig-alkalischen — Entwicklerlösungsmitteln lösliche oder dispergierbare Resistschicht aufgebracht, diese Resistschicht bildmäßig mit aktinischem Licht belichtet wird und anschließend die nicht belichteten Bereiche der Resistschicht mit dem Entwicklerlösungsmittel ausgewaschen werden.

Trockenfilmresists der in Rede stehenden Art sind bekannt und finden breite Anwendung zur Herstellung von Resistmustern in der Ätz- oder Galvano-Technik, bei der Herstellung von Leiterplatten sowie Dünnschicht- und Mehrschichtschaltungen. Dabei gewinnen die wäßrig entwickelbaren Photoresists wegen ihrer umweltfreundlicheren Verarbeitbarkeit im Vergleich zu den mit organischen Lösungsmitteln entwickelbaren Resists immer stärker an Bedeutung. Die photopolymerisierbare Resistschicht besteht dabei im allgemeinen aus einer Mischung von mindestens einem in wäßrigen Medien, insbesondere wäßrig-alkalischen Medien, löslichen bzw. dispergierbaren polymeren Bindemittel, mindestens einer ethylenisch ungesättigten, photopolymerisierbaren niedermolekularen Verbindung, mindestens einem Photoinitiator sowie gegebenenfalls weiteren Zusatz- und/oder Hilfsstoffen.

Als polymere Bindemittel für die wäßrig entwickelbaren Resistschichten sind insbesondere Carboxyl-Gruppen oder Carbonsäureanhydrid-Gruppen enthaltende Polymere vorgeschlagen worden, wie z. B. Alkyl-(meth)acrylat/(Meth)acrylsäure-Copolymerisate, Styrol/Maleinsäureanhydrid-Copolymerisate, Styrol/Maleinsäurehalbester-Copolymerisate oder auch Styrol/Alkyl-(meth)acrylat/(Meth)acrylsäure-Copolymerisate (vgl. u. a. DE-B-20 64 080, DE-A-22 05 146 und EP-A-49 504). Als photopolymerisierbare niedermolekulare Verbindungen für diese Resistschichten sind verschiedenartige Acrylat- und Methacrylat-Verbindungen beschrieben, wobei die photopolymerisierbaren Resistschichten üblicherweise 40 bis 90 Gew.% der polymeren Bindemittel und 10 bis 60 Gew.% der photopolymerisierbaren niedermolekularen Verbindungen enthalten.

An die photopolymerisierbaren Resistmaterialien werden — neben der Entwickelbarkeit mit wäßrigen Medien — eine Reihe weiterer, verschiedenartiger Anforderungen gestellt. So müssen die photopolymerisierbaren Mischungen gute Filmbildungseigenschaften aufweisen und sich zu festen, vorzugsweise nicht klebrigen, Schichten verarbeiten lassen. Die Resistschichten der Photoresistfilme müssen sich auf Substrate auflaminieren lassen und eine gute Haftung gegenüber diesen Substraten aufweisen. Dabei ist eine gute Haftungsdifferenzierung sowohl zwischen photopolymerisierbarer Resistschicht und Deckfolie einerseits und photopolymerisierbaren Resistschicht und temporärem Träger andererseits als auch zwischen photopolymerisierbarer Resistschicht und temporärem Träger einerseits und photopolymerisierbarer Resistschicht und Substrat andererseits notwendig. Ferner werden kurze Belichtungs- und Entwicklungszeiten gefordert bei gleichzeitig guter Differenzierung zwischen belichteten und unbelichteten Bereichen und Ausbildung exakter und scharfer Konturen der Resistmuster. Die entwickelten Resistmuster müssen darüber hinaus gute mechanische Eigenschaften besitzen und gegenüber den Chemikalien, wie sie bei der Weiterverarbeitung zur Anwendung kommen, insbesondere Ätz- und Galvanisierbädern, beständig sein. Die bisher vorgeschlagenen Trockenfilmresists mit photopolymerisierbaren, wäßrig entwickelbaren Resistschichten sind hinsichtlich der an diese Materialien gestellten Forderungen immer noch weiter verbesserungsbedürftig.

In der DE-A-27 36 058 wird ein Trockenfilmresist beschrieben, der ohne Zusatz von organischen Stoffen rein wäßrig-alkalisch entwickelbar ist und gleichzeitig im belichteten Zustand eine gute chemische Beständigkeit aufweisen soll. Die photopolymerisierbare Resistschicht dieses Trockenfilmresists enthält ein carboxylgruppenhaltiges, wasserunlösliches Copolymerisat als Bindemittel, ein polares, hydroxylgruppenhaltiges Oligomeres, welches durch Anlagerung einer Mono- oder Dicarbonsäure, wie z. B. (Meth)acrylsäure, Maleinsäure oder Fumarsäure, an ein Epoxidharz erhalten worden ist, sowie ein polyfunktionelles (Meth)acrylat-Monomeres im Gewichtsverhältnis polymeres Bindemittel zu Oligomer zu Monomer von 1 : 0,15-1 : 0,15-1. Auch dieser Trockenfilmresist ist hinsichtlich seiner anwendungstechnischen Eigenschaften noch nicht zufriedenstellend.

Weiterhin sind aus der DE-A-29 17 483 photopolymerisierbare Massen für die Herstellung von Druckplatten bekannt, die mit basischen Lösungen schnell entwickelbar sind, eine hohe Strahlungsempfindlichkeit bei gleichzeitig hoher Sauerstoffunempfindlichkeit besitzen und auf bestimmten Trägermaterialien, wie z. B. Aluminiumoberflächen, gut haften. Diese photopolymerisierbaren Massen bestehen im wesentlichen aus einem organischen filmbildenden Polymerisat, einem polymerisierbaren Monomeren, einem polymerisierbaren, carboxylgruppenhaltigen, oligomeren Urethan-(meth)-acrylat-Harz sowie einem Photoinitiator, wobei das filmbildende Polymerisat, das Monomere und das Oligomere jeweils in Mengen von 10 bis 60 Gew.% in der photopolymerisierbaren Masse enthalten sein können. Auf die Herstellung von Resistmustern für die dauerhafte Modifizierung von Substraten und die Eignung solcher photopolymerisierbaren Massen für die Herstellung von Trockenfilmresists findet sich in dieser Druckschrift kein Hinweis.

# 0 186 091

Die US-A-4 228 232 betrifft eine photopolymerisierbare Zusammensetzung, bestehend aus einem ethylenisch ungesättigten Oligomeren, das Urethangruppen und Carboxylgruppen enthält, einem organischen filmbildenden Polymeren, einem radikalisch polymerisierbaren ethylenisch ungesättigten Monomeren und einem Photoinitiatorsystem, die zur Herstellung von Offset-Druckplatten verwendet wird.

In FR-A-2 361 681 werden Photoresistschichten beschrieben, die zwischen Polymerfilmen eine photoempfindliche Schicht aus einem carboxylierten Polymeren, einem polaren Oligomeren und einem Monomeren enthalten, wobei das polare Oligomere ein Additionsprodukt der (Meth-)acrylsäure an ein Epoxidharz ist, also ein lineares Additionsprodukt, das nich kettenverlängert oder verzweigt ist. Die hier in den Beispielen genannten Oligomeren weisen Säurezahlen < 50 mg KOH/g auf; der Gehalt an carboxylierten Polymeren liegt durchwegs über 35 Gew.% und der an Oligomeren deutlich unter 40 Gew.%.

Schließlich werden in der DE-A-24 42 527 und der DE-C-25 57 408 vernetzbare, Acryloyl- und/oder Methacryloylgruppen sowie Carboxylgruppen enthaltende, oligomere Harze beschrieben, die durch Umsetzung von Polyepoxiden, (Meth)acrylsäure und cyclischen Dicarbonsäureanhydriden, sowie gemäß der DE-C-25 57 408 auch unter Mitverwendung von Di- oder Polyisocyanaten hergestellt worden sind. Ebenfalls ist der Einsatz dieser Harze in photopolymerisierbaren Resistschichten erwähnt, wobei die in diesen Druckschriften beschriebenen photopolymerisierbaren Resistschichten zwar vergleichsweise sauerstoffunempfindlich sind und sich nach der Belichtung und Entwicklung durch eine gute Haftung auf metallischen Trägermaterialien auszeichnen, jedoch ebenfalls nicht voll befriedigen. So neigen sie u. a. vielfach zum Verkleben, sind die belichteten Schichten spröde oder sind auch das Tenting-Verhalten oder die für Trockenfilmresists geforderte Haftungsdifferenzierung der Resistschichten gegenüber Deckfolie und temporären Träger bzw. temporären Träger und Substrat ungenügend.

Die Aufgabe der vorliegenden Erfindung liegt in der Schaffung eines neuen, verbesserten Trockenfilmresists mit einer wäßrig, insbesondere wäßrig-alkalisch, entwickelbaren, photopolymerisierbaren Resistschicht, der gute verarbeitungs- und anwendungstechnische Eigenschaften aufweist und mit dem nach den an sich bekannten Verfahren auf einem Substrat Resistmuster hoher Qualität hergestellt werden können.

Es wurde nun gefunden, daß diese Aufgabe durch Trockenfilmresists mit einem temporären Träger, einer photopolymerisierbaren, wäßrig, insbesondere wäßrig-alkalisch, entwickelbaren Resistschicht sowie gegebenenfalls einer abziehbaren Deckfolie gelöst wird, bei denen die photopolymerisierbare Resistschicht aus einer homogenen, photopolymerisierbaren Mischung besteht, die spezielle photopolymerisierbare Oligomere, spezielle polymere Bindemittel, verträgliche photopolymerisierbare Monomere, Photoinitiatoren sowie gegebenenfalls weitere Zusatz- und/oder Hilfsstoffe in einem zahlenmäßig bestimmten Verhältnis zueinander enthält.

Gegenstand der Erfindung ist demzufolge ein Trockenfilmresist mit einem temporären, dimensionsstabilen Schichtträger, einer auf dem temporären Schichtträger aufgebrachten, festen, unter Anwendung von Druck sowie gegebenenfalls Wärme auf ein Substrat übertragbaren, in wäßrigen, insbesondere wäßrig-alkalischen, Entwicklermedien löslichen oder zumindest dispergierbaren, photopolymerisierbaren Resistschicht sowie gegebenenfalls einer abziehbaren Deckfolie auf der photopolymerisierbaren Resistschicht, welcher dadurch gekennzeichnet ist, daß die photopolymerisierbare Resistschicht gebildet wird aus einer homogenen Mischung von

a) mindestens 40 Gew.%, insbesondere mehr als 45 Gew.%, mindestens eines photopolymerisierbaren, in wäßrig-alkalischen Lösungen löslichen oder zumindest dispergierbaren, freie Carboxyl-Gruppen und mehr als zwei Acryloyl- und/oder Methacryloyl-Gruppen enthaltenden Oligomeren mit einem mittleren Molekulargewicht (Zahlenmittel) im Bereich von etwa 1 000 bis etwa 10 000 und einer Säurezahl im Bereich von 50 bis 150 mg KOH/g, erhältlich durch Umsetzung einer Acryloyl und/oder Methacryloyl-Gruppen enthaltenden Diol- oder Polyol-Verbindung mit dem Anhydrid einer mehrbasischen Carbonsäure, insbesondere cyclischen Carbonsäureanhydriden, unter Veresterung aller oder nur eines Teils der Hydroxylgruppen der Diol- oder Polyolverbindung unter Bildung der sauren Teilester der mehrbasischen Carbonsäure und weitere Umsetzung eines Teils der freien Carboxylgruppen des so erhaltenen Reaktionsproduktes mit einem Di- oder Polyepoxid unter Kettenverlängerung sowie gegebenenfalls Verzweigung des Produktes;

b) 1 bis 35 Gew.%, insbesondere 10 bis 30 Gew.%, mindestens eines filmbildenden, in Wasser oder in wäßrig-alkalischen Lösungen löslichen oder zumindest dispergierbaren, mit den Oligomeren der Komponente a) verträglichen Polymeren mit einem mittleren Molekulargewicht (Gewichtsmittel) größer als 15 000;

c) 1 bis 30 Gew.%, insbesondere 10 bis 25 Gew.%, mindestens eines mit den Oligomeren der Komponente a) und den Polymeren der Komponente b) verträglichen photopolymerisierbaren Monomeren;

d) 0,001 bis 10 Gew.%, insbesondere 0,1 bis 5 Gew.%, mindestens eines Photopolymerisationsinitiators sowie

e) 0 bis 30 Gew.%, insbesondere 0,05 bis 12 Gew.%, an weiteren Zusatz und/oder Hilfsstoffen.

wobei sich die Prozentangaben für die einzelnen Komponenten jeweils auf die gesamte Mischung beziehen.

Gegenstand der Erfindung ist weiterhin ein Verfahren zur Herstellung von Resistmustern auf einem Substrat, bei dem auf das Substrat eine feste, photopolymerisierbare, in wäßrigen, insbesondere wäßrig-alkalischen, Entwicklerlösungsmitteln lösliche bzw. dispergierbare Resistschicht aufgebracht, diese Resistschicht bildmäßig mit aktinischem Licht belichtet wird und anschließend die nichtbelichteten Bereiche der Resistschicht mit dem Entwicklerlösungsmittel ausgewaschen werden. Das Verfahren ist dadurch gekennzeichnet, daß die photopolymerisierbare Resistschicht aus einer homogenen, photopolymerisierbaren Mischung, wie vorstehend für die Resistschicht des erfindungsgemäßen Trockenfilmresist angegeben, besteht.

Die erfindungsgemäß für die Herstellung der Trockenfilmresists und der Resistmuster einzusetzenden photopolymerisierbaren Resistschichten zeigen im Vergleich zu den bekannten Photoresists eine Reihe vorteilhafter und z. T überraschender Eigenschaften. Die festen photopolymerisierbaren Resistschichten sind nicht klebrig und lassen sich bei der Verarbeitung gut und ohne besondere Sicherheitsvorkehrungen handhaben. Sie zeigen eine gute Haftungsdifferenzierung ; eine bei den Trockenfilmresists gegebenenfalls vorhandene Deckfolie bei den Trockenfilmresists läßt sich problemlos abziehen. Die photopolymerisierbare Resistschicht der erfindungsgemäßen Trockenfilmresists ist sehr gut laminierbar und läßt sich einfach auf Substrate, wie sie als Untergrund für die Herstellung der Resistmuster dienen, insbesondere Metalle, metallische oder metalloxidische Oberflächen, übertragen. Die erfindungsgemäße Resistschicht zeigt dabei nach der Übertragung sowohl im unbelichteten als auch im belichteten Zustand eine sehr gute Haftung gegenüber dem Substrat, ohne daß es jedoch bei der Herstellung der Resistmuster zu Restschichtbildungen kommt. Der temporäre Träger der Trockenfilmresists läßt sich nach dem Auflaminieren bzw. Aufkaschieren der Resistschicht auf das Substrat ohne weiteres von dieser, vorteilhafterweise vor der bildmäßigen Belichtung abziehen. Die erfindungsgemäßen photopolymerisierbaren Resistschichten besitzen sehr gute Belichtungseigenschaften, ein hohes Auflösungsvermögen und ermöglichen bei kurzer Entwicklungsdauer, insbesondere mit wäßrig-alkalischen Entwicklerlösungen eine sehr gute und exakte Differenzierung zwischen belichteten und unbelichteten Bereichen, so daß auch Resistmuster mit feinen Bildelementen korrekt und vorlagengetreu hergestellt werden können. Die erfindungsgemäß hergestellten Resistmuster haben eine hohe mechanische Beständigkeit und sind trotz ihrer wäßrigen Entwickelbarkeit gegenüber den üblicherweise verwendeten sauren Ätz- und Galvanikbädern stabil und besitzen zum Teil auch zusätzlich eine gute Stabilität in ammoniakalischen Ätzbädern.

Der temporäre Schichtträger der erfindungsgemäßen Trockenfilmresists ist dimensionsstabil und vorzugsweise transparent. Er hat eine mäßige Haftung zur photopolymerisierbaren Resistschicht, so daß er nach dem Auflaminieren oder Aufkaschieren der Resistschicht auf das Substrat — wahlweise vor oder nach der bildmäßigen Belichtung der Resistschicht — von dieser abgezogen werden kann, ohne daß hierbei die Resistschicht wieder von dem Substrat abgelöst oder anderweitig beschädigt wird.. Der temporare Schichtträger kann auch in dem Entwicklerlösungsmittel für die Resistschicht löslich sein, so daß er bei der Entwicklung des Resistmusters zusammen mit ·den unbelichteten Bereichen der Resistschicht abgewaschen wird ; in diesem Fall braucht der temporäre Schichtträger nicht unbedingt von der photopolymerisierbaren Resistschicht abziehbar zu sein. Der temporäre Schichtträger wird insbesondere aus Kunststofffilmen oder -folien gebildet, beispielsweise Polyamiden, Polyolefinen, Polyestern, Vinylpolymerisaten, Celluloseestern und ähnlichen. Besonders bevorzugt als temporäre Schichtträger sind Filme oder Folien aus Polyestern, beispielsweise Polyethylenterephthalat oder Polybutylenterephthalat. Der temporäre Schichtträger hat im allgemeinen eine Dicke im Bereich von etwa 10 bis 150 µm, insbesondere etwa von 20 bis 40 µm. Gegebenenfalls kann es vorteilhaft sein, oberflächlich vorbehandelte Kunststofffilme oder -folien als temporären Schichtträger einzusetzen. Eine solche Vorbehandlung kann beispielsweise in dem Aufrauhen der Oberfläche des temporären Schichtträgers bestehen, um so beispielsweise eine mattierte Oberfläche der auf das Substrat übertragenen photopolymerisierbaren Resistschicht zu erhalten.

Die photopolymerisierbare Resistschicht wird erfindungsgemäß aus mindestens einem photopolymerisierbaren Oligomeren (Komponente a), mindestens einem filmbildenden, in den wäßrigen Entwicklerlösungsmitteln löslichen oder zumindest dispergierbaren Polymeren (Komponente b), mindestens einem photopolymerisierbaren Monomeren (Komponente c), mindestens einem Photopolymerisationsinitiator (Komponente d) sowie gegebenenfalls weiteren Zusatz- und/oder Hilfsstoffen (Komponente e) in den vorstehend angegebenen, bestimmten Mengenverhältnissen zueinander gebildet. Die einzelnen Komponenten, insbesondere (a) bis (c), sind dabei so ausgewählt und aufeinander abgestimmt, daß sie miteinander verträglich sind und daß das für die bildmäßige Belichtung verwendete aktinische Licht in der Resistschicht nicht gestreut wird. Die erfindungsgemäß einzusetzende, wäßrig entwickelbare, photopolymerisierbare Resistschicht ist fest, nicht klebrig und gut laminierbar und auf Substrate übertragbar. Die Dicke der photopolymerisierbaren Resistschicht liegt üblicherweise im Bereich von etwa 15 bis 70 µm, sie kann je nach Anwendungsgebiet des Photoresists jedoch auch darunter oder darüber liegen.

Die erfindungsgemäße photopolymerisierbare Resistschicht enthält als Komponente a) mindestens ein in wäßrig-alkalischen Lösungen, vorzugsweise mit einem pH-Wert von etwa 9 bis 13, lösliches oder dispergierbares, photopolymerisierbares und vernetzbares Oligomeres mit freien Carboxyl-Gruppen und mehr als 2 Acryloyl- und/oder Methacryloyl-Gruppen. Das mittlere Molekulargewicht (Zahlenmittel) der als Komponente a) einzusetzenden Oligomeren liegt im Bereich von etwa 1 000 bis etwa 10 000, insbesondere im Bereich von etwa 1 500 bis 6 000. Vorzugsweise werden bei Raumtemperatur feste Oligomere der in Rede stehenden Art verwendet. Insbesondere kommen als Komponente a) solche oligomere Polyadditions- oder Polykondensationsharze, d. h. oligomere Harze, die durch Polyadditions- oder Polykondensationsreaktion hergestellt worden sind, in Betracht. Der Anteil der Acyloyl- und/oder Methacryloyl-Gruppen in den Oligomeren beträgt mehr als zwei und liegt vorzugsweise im Mittel im Bereich von insgesamt etwa 2,1 bis 8 Acryloyl- und/oder Methacryloyl-Gruppen po Molekül. Insbesondere enthalten die Oligomeren im Mittel insgesamt 2,5 bis 6 acrylische und/oder methacrylische Doppelbindungen pro Molekul. Die als Komponente a) einzusetzenden Oligomeren enthalten neben den Acryloyl- und/oder Methacryloyl-Gruppen im allgemeinen keine weiteren, zusätzlichen ethylenisch ungesättigten, photopolymerisierbaren Doppelbindungen mehr. Der Gehalt an freien Carboxylgruppen in den Oligomeren wird unter anderem maßgeblich von dem Erfordernis mitbestimmt, daß die Oligomeren in wäßrig-alkalischen Lösungen löslich oder dispergierbar sein sollen, vorzugsweise jedoch noch nicht bei pH-Werten kleiner als 9. Die Säurezahl der erfindungsgemäß einzusetzenden Oligomeren liegt dementsprechend nicht unter 50 mg KOH/g. Der Gehalt an freien Carboxylgruppen hängt dabei auch von den weiteren Strukturmerkmalen der jeweiligen Oligomeren ab, wie z. B. dem Gehalt an freien Hydroxylgruppen, dem Anteil an hydrophilen Ethersegmenten etc. Die Oligomeren haben eine Säurezahl im Bereich von 50 bis 150 mg KOH/g ; vorzugsweise im Bereich von 60 bis 120 mg KOH/g. Da die photopolymerisierbaren Resistschichten vorzugsweise aus Lösung hergestellt werden, sind die erfindungsgemäß einzusetzenden in organischen Lösungsmitteln, bevorzugt leicht verdunstenden, polaren Lösungsmitteln, wie z. B. Methanol, Aceton, Methylethylketon, Essigsäureethylester u. a., löslich.

Die Oligomeren können in der photopolymerisierbaren Resistschicht allein oder in Mischung miteinander eingesetzt werden und machen mindestens 40 Gew.%, insbesondere mehr als 45 Gew.% der die Resistschicht bildenden photopolymerisierbaren Mischung aus. Die obere Grenze für den Gehalt an Oligomeren in der Resistschicht bestimmt sich aus den Mengen, in denen die übrigen Komponenten in der photopolymerisierbaren Resistschicht enthalten sind. Vorzugsweise liegt der Gehalt an den Oligomeren der Komponente a) nicht über 90 Gew.%, vorzugsweise bei 75 Gew.%, bezogen auf die die Resistschicht bildende photopolymerisierbare Mischung. Erfindungsgemäß haben sich solche photopolymerisierbaren Resistschichten als besonders günstig erwiesen, die etwa 50 bis 65 Gew.% an Oligomeren der Komponente a), bezogen auf die die Resistschicht bildende photopolymerisierbare Mischung, enthalten.

Als Oligomere für die Komponente a) der photopolymerisierbaren Resistschichten haben sich auf Grund der guten und vorteilhaften Eigenschaften der damit erfindungsgemäß hergestellten Trockenfilmresists und Resistmuster, beispielsweise der guten Stabilität der Resistmuster selbst in ammoniakalischen Ätzbädern solche freie Carboxylgruppen und Acryloyl- und/oder Methacryloylgruppen enthaltenden Oligomeren auf Basis von Epoxiden als besonders günstig erwiesen, wie sie erhalten werden durch Umsetzung von Acryloyl- und/oder Methacryloyl-Gruppen enthaltenden Diol- oder Polyol-Verbindungen, mit Anhydriden mehrbasischer Carbonsäuren, insbesondere cyclischen Carbonsäureanhydriden, unter Ausbildung der sauren Teilester dieser mehrbasischen Carbonsäuren und anschließende kettenverlägernde Umsetzung eines Teils der freien Carboxylgruppen des so erhaltenen Reaktionsprodukts mit einer Di- und/oder Polyepoxid-Verbindung. Als (Meth)acryloyl-Gruppen enthaltende Diol- oder Polyol-Verbindung für die Herstellung dieser Oligomeren kommen insbesondere Umsetzungsprodukte von Acryl- und/oder Methacrylsäure mit Di- oder Polyepoxid-Verbindungen oder mit OH-Gruppen tragenden Monoepoxiden in Betracht. Als beispiel für OH-Gruppen tragende Monoepoxide sei hierbei das Glycidol genannt. Als Di- oder Polyepoxide für die Umsetzung mit der (Meth)acrylsäure kommen Verbindungen mit zwei oder mehr Glycidylgruppen in Betracht, wie z. B. Di- oder Polyglycidylether mehrwertiger Alkohole und insbesondere mehrwertiger Phenole oder Di- oder Polyglycidylester mehrwertiger aliphatischer, cycloaliphatischer und insbesondere aromatischer Carbonsauren ; insbesondere vorteilhaft sind hier die aromatischen Di- und Polyglycidylverbindungen, bei denen die Glycidylreste direkt oder indirekt an ein- oder mehrkernige, gegebenenfalls substituierte, aromatische Ringe bzw. Ringsysteme gebunden sind. Als Beispiele für geeignete Di- und Polyglycidylether seien die Umsetzungsprodukte von Epichlorhydrin mit Bisphenol A oder Bisphenol A-Derivaten, z. B. Substitutionsprodukten von Bisphenol A genannt. Zu den geeigneten Di- und Polyglycidylestern gehören u. a. Phthalsäurediglycidylester, Isophthalsäurediglycidylester, Terephthalsäurediglycidylester und Hexahydrophthalsäurediglycidylester. Die genannten Di- und Polyepoxide können vor oder während der Umsetzung mit der Acryl- und/oder Methacrylsäure auch noch durch Umsetzung mit aliphatischen, cycloaliphatischen oder aromatischen Dicarbonsäuren bzw. gegenüber Glycidylgruppen reaktiven Dicarbonsäurederivaten vorverlangert werden. Zu diesem Zweck kommen beispielsweise Phthalsäure, Isophthalsäure, Terephthalsäure, Hexahydrophthalsäure, Malonsäure, Bernsteinsäure, Methylbernsteinsäure, Adipinsäure bzw. deren gegenüber Glycidylgruppen reaktiven Derivate in Betracht, wobei Phthalsäure und Adipinsäure bzw. deren Derivate bevorzugt sind. Die, gegebenenfalls vorverlängerten, Di- oder Polyepoxide werden mit der Acryl- und/oder Methacrylsäure insbesondere in einem Äquivalentverhältnis Glycidyl-Gruppen : COOH-Gruppen von 1 : 0,5-1, insbesondere von etwa 1 : 1, umgesetzt. Wird die Vorverlängerung der Di- oder Polyepoxide mit den Dicarbonsäuren bzw. deren Derivaten gleichzeitig mit der Umsetzung mit der Acryl- und/oder Methacrylsäure vorgenommen, d. h.

5

werden die Di- oder Polyepoxide mit einem Gemisch aus Dicarbonsäuren bzw. Dicarbonsäurederivaten der genannten Art und Acryl und/oder Methacrylsäure umgesetzt, dann liegen in dem Carbonsäure-Gemisch die Dicarbonsäuren bzw. deren Derivate einerseits und die Acrylsäure und/oder Methacrylsäure andererseits vorzugsweise jeweils in Mengen von 30 bis 70 Mol.%, bezogen auf das Carbonsäuregemisch, vor und liegt das Äquivalentverhältnis Glycidyl-Gruppen : Gesamt-COOH-Gruppen bei dieser Umsetzung insbesondere bei etwa 1 : 1. Als vorteilhaft für die Herstellung von Oligomeren dieser Art haben sich dabei beispielsweise solche (Meth)-acryloyl-Gruppen haltigen Diol- oder Polyol-Verbindungen erwiesen, die durch Umsetzung von Bisphenol A-Diglycidylethern, insbesondere dem aus Bisphenol A und Epichlorhydrin erhältichen Diglycidylether, mit Acrylsäure im Äquivalentverhältnis Glycidyl-Gruppen : COOH-Gruppen von etwa 1 : 1 oder durch Umsetzung von Bisphenol A-Diglycidylethern, insbesondere dem durch Umsetzung von Epichlorhydrin mit Bisphenol A erhältlichen Diglycidylether, mit einem Gemisch aus Adipinsäure und Acrylsäure in einem Äquivalentverhältnis von Glycidyl-Gruppen : COOH-Gruppen der Adipinsäure : COOH-Gruppen der Acrylsäure von 1 : 0,4-0,6 : 0,6-0,4 bei einem Äquivalentverhältnis Glycidyl-Gruppen : Gesamt-COOH-Gruppen von etwa 1 :1 hergestellt worden sind. Diese Acryloyl- und/oder Methacryloyl-Gruppen enthaltenden Diol- oder Polyoyl-Verbindungen werden zur Einführung der freien Carboxylgruppen mit den Anhydriden mehrbasischer Carbonsäuren, insbesondere cyclischen Carbonsäureanhydriden, wie z. B. mit cyclischen Dicarbonsäureanhydriden, in einer solchen Weise umgesetzt, daß die Hydroxylgruppen der Diol- oder Polyol-Verbindungen mit den Anhydriden mehrbasischer Carbonsäuren unter Bildung von sauren Teilestern dieser Carbonsäuren reagieren. Sofern die Acryloyl- und/oder Methacryloyl-Gruppen enthaltenden Diol- oder Polyol-Verbindungen von ihrer Herstellung her auch noch Glycidylgruppen enthalten, werden auch diese mit den Anhydriden mehrbasischer Carbonsäuren umgesetzt. Vorzugsweise wird die Reaktion so geführt, daß alle Hydroxylgruppen sowie gegebenenfalls noch in der Diol- oder Polyol-Verbindung enthaltenden Glycidyl-Gruppen mit den Anhydriden mehrbasischer Carbonsäuren unter Bildung der sauren Teilester dieser Carbonsäuren umgesetzt werden. Als Anhydride mehrbasischer Carbonsäuren kommen die Anhydride aliphatischer, cycloaliphatischer und vorzugsweise aromatischer Dicarbonsäuren und speziell die cyclischen Anhydride von Di- und/oder Tricarbonsäuren zur Anwendung. Geeignete Dicarbonsäureanhydride für diese Umsetzung sind z. B. die Anhydride der Phthalsäure, Isophthalsäure, Terephthalsäure, Trimellithsäure, Hexahydrophthalsäure, Malonsäure, Bernsteinsäure, Adipinsäure und andere. Als besonders vorteilhaft haben sich hier die Anhydride aromatischer Di- und/oder Tricarbonsäuren, sowie speziell deren cyclische Anhydride, wie Phthalsäureanhydrid oder Mischungen von Phthalsäureanhydrid mit anderen Carbonsäureanhydriden, insbesondere Mischungen von Phthalsäureanhydrid mit Trimellithsäureanhydrid, erwiesen. In den Mischungen von Phthalsäureanhydrid mit den anderen Carbonsäureanhydriden liegt das Mischungsverhältnis vorzugsweise im Bereich von etwa 65 bis 95 Mol.%, insbesondere 75 bis 90 Mol.%, an Phthalsäureanhydrid und etwa 5 bis 35 Mol.%, insbesondere 10 bis 25 Mol.%, der anderen Carbonsäureanhydride. Bei der Umsetzung der Acryloyl- und/oder Methacryloyl-Gruppen enthaltenden Diol- oder Polyol-Verbindungen mit den cyclischen Carbonsäureanhydriden liegt das Äquivalentverhältnis OH-Gruppen : Anhydrid-Gruppen vorzugsweise im Bereich von etwa 1 : 0,8 bis 1 : 1,2. Die bei der Teilveresterung der Carbonsäureanhydride mit den die Acryloyl- und/oder Methacryloyl-Gruppen enthaltenden Diol- oder Polyol-Verbindungen gebildeten freien Carboxyl-Gruppen werden anschließend teilweise mit Di- und/oder Polyepoxiden unter Kettenverlängerung sowie gegebenenfalls Verzweigung zu den gewünschten Oligomeren umgesetzt. Als Di- und Polyepoxide für die Kettenverlängerung sowie gegebenenfalls Verzweigung können grundsätzlich alle Verbindungen mit zwei oder mehr Glycidylgruppen verwendet werden, wie beispielsweise die Umsetzungsprodukte von Epichlorhydrin mit Di- oder Polyolen, die Umsetzungsprodukte von Epichlorhydrin mit Di- oder Polyaminen, Polyolefinepoxide, Epoxyharze vom Novolak-Typ sowie Glycidylester von Di- oder Polycarbonsäuren. So kommen gleichermaßen Di- und Polyglycidylether von aliphatischen Di- und Polyolen, wie beispielsweise von 1,4-Butandiol, Glycerin, Trimethylolpropan, Pentaerythrit oder Polyethylenglykolen, wie auch Di- und Polyglycidylether von ein- oder mehrkernigen aromatischen Di- und Polyhydroxyverbindungen, wie z. B. von mehrwertigen Phenolen, sowie weiterhin die Di-und Polyglycidylester aliphatischer, cycloaliphatischer oder aromatischer Di- oder Polycarbonsäuren, wie z. B. Adipinsäure, Hexahydrophthalsäure, Phthalsäure, Isophthalsäure oder Terephthalsäure, in Betracht. Als besonders vorteilhaft haben sich hier die Di- und Polyglycidylether aliphatischer Di- und Polyole, wie z. B. Pentaerythrittriglycidylether, sowie die Bisglycidylether von Bisphenol A oder den Substitutionsprodukten von Bisphenol A, wie z. B. der Bisglycidylether aus Epichlorhydrin und Bisphenol A erwiesen. Bei der kettenverlängernden Umsetzung der freien Carboxyl-Gruppen des zuvor erzeugten Reaktionsproduktes mit den Di- und/oder Polyepoxiden liegt das Äquivalentverhältnis COOH-Gruppen : Glycidylgruppen unter 1 : 1, vorzugsweise im Bereich von etwa 1 : 0,8 bis 1 : 0,2 und insbesondere im Bereich von etwa 1 : 0,6 bis etwa 1 : 0,25.

Die Herstellung der als Komponente a) der erfindungsgemäßen photopolymerisierbaren Resistschicht einzusetzenden Oligomeren kann nach den üblichen und an sich bekannten Verfahrensweisen für Polykondensations- bzw. Polyadditionsreaktionen, vorteilhafterweise in Lösung sowie gegebenenfalls in Gegenwart geeigneter Katalysatoren, erfolgen. Die Reaktionen werden vorteilhafter Weise so geführt, daß die resultierenden Oligomeren in organischen Lösungsmitteln löslich sind. Dies ist im Hinblick auf die Verarbeitbarkeit der Oligomeren bei der Herstellung der erfindungsgemäßen photopolymerisierbaren Resistschichten von Bedeutung. Vorzugsweise werden als Komponente a) oligomere, durch Polykondensations- bzw. Polyadditionsreaktion hergestellte, urethangruppenfreie Harze der in Rede stehenden Art eingesetzt, insbesondere solche auf Basis von Di- und/oder Polyepoxiden, und speziell solche, wie sie nach der vorstehend zuletzt angesprochenen Herstellungsmethode erhältlich sind.

Neben den genannten Oligomeren enthalten die erfindungsgemäßen photopolymerisierbaren Resistschichten als Komponente b) in einer Menge von 1 bis 35 Gew.%, insbesondere in einer Menge von 10 bis 30 Gew.%, bezogen auf die die photopolymerisierbare Resistschicht bildende homogene Mischung, ein oder mehrere, mit den Oligomeren der Komponente a) verträgliche Polymere. Diese Polymeren sollen filmbildende Eigenschaften besitzen und in Wasser oder in wäßrig-alkalischen Lösungen, wie sie für die Entwicklung der bildmäßig belichteten Resistschichten eingesetzt werden, löslich oder zumindest dispergierbar sein. Die Polymeren sollen im Hinblick auf die Verarbeitbarkeit und Herstellung der photopolymerisierbaren Resistschichten, ebenso wie die Oligomeren der Komponente a), vorzugsweise auch in niedrigsiedenden, organischen Lösungsmitteln löslich sein. Vorteilhafterweise sind die Oligomeren der Komponente a) und die Polymeren der Komponente b) in den gleichen organischen Lösungsmitteln oder Lösungsmittelgemischen löslich. Das mittlere Molekulargewicht (Gewichtsmittel) der Polymeren der Komponente b) ist größer als etwa 15 000 und im allgemeinen auch größer 20 000. Insbesondere liegt das mittlere Molekulargewicht (Gewichtsmittel) der Polymeren der Komponente b) zwischen 15 000 und 500 000, bevorzugt zwischen 20 000 und 250 000.

Als Beispiele für wasserlösliche Polymere, die als Komponente b) in den photopolymerisierbaren Resistschichten enthalten sein können, seien die entsprechenden filmbildenden Homo- und Copolymerisate von N-Vinyllactamen, insbesondere von N-Vinylpyrrolidon und N-Vinylcaprolactam genannt, wie z. B. Poly-N-vinylpyrrolidon, N-Vinylpyrrolidon/Vinylacetat-Copolymerisate oder besonders N-Vinylpyrrolidon/Vinylpropionat-Copolymerisate, wobei der Anteil des N-Vinylpyrrolidons in diesen Copolymerisaten vorzugsweise im Bereich von etwa 50 bis 90 Gew.%, bezogen auf das Copolymerisat, liegt. Die wasserlöslichen Polymeren sind als Komponente b) in den erfindungsgemäßen photopolymerisierbaren Resistschichten insbesondere dann geeignet, wenn der Resist für die Ätzanwendung eingesetzt werden soll. Für andere Anwendungsbereiche, insbesondere in der Galvanik, sind die rein wasserlöslichen Polymeren als Komponente b) weniger vorteilhaft.

Vorzugsweise werden als Komponente b) in den erfindungsgemäßen photopolymerisierbaren Resistschichten solche filmbildenden Polymere eingesetzt, die in wäßrig-alkalischen Lösungen, insbesondere mit einem pH-Wert von etwa 9 bis 13, und vorzugsweise nicht bei einem pH-Wert kleiner etwa 9, löslich oder zumindest dispergierbar sind. Hierzu gehören die für wäßrig-entwickelbare photopolymerisierbare Resistschichten an sich bekannten und üblichen polymeren Bindemittel. Insbesondere handelt es sich hierbei um Copolymerisate von einem oder mehreren Vinyl-Monomeren, die als solche wasserunlösliche Homopolymerisate bilden, mit einem oder mehreren Monomeren mit freien Säure-Gruppen, insbesondere Sulfonsäure- oder Carboxyl-Gruppen, oder mit cyclischen Anhydrid-Gruppierungen. Als Beispiele für die Vinyl-Monomeren seien genannt : Vinylaromaten, wie insbesondere Styrol oder auch substituierte Styrole ; Ester von Acrylsäure oder Methacrylsäure, wie z. B. Acrylate oder Methacrylate von Alkanolen mit 1 bis 20 C-Atomen, etwa Methyl(meth)acrylat, Ethyl(meth)acrylat, Butyl(meth)-acrylat oder Hexyl(meth)acrylat, Glycidyl(meth)acrylat, und dgl. ; (Meth)-acrylnitril ; Vinylacetat, Vinylpropionat ; Vinylchlorid ; Vinylalkylketone, insbesondere mit 1 bis 4 C-Atomen im Alkylrest ; Vinylalkylether, insbesondere mit 1 bis 8 C-Atomen im Alkylrest. Bei der zweiten Gruppe der Comonomeren, den Monomeren mit den sauren Gruppen oder den cyclischen Anhydrid-Gruppierungen, sind insbesondere beispielhaft zu nennen : Acrylsäure, Methacrylsäure, Crotonsäure, Maleinsäure, Fumarsäure, Maleinsäurehalbester, Maleinsäureanhydrid. Als weitere Gruppe von Comonomere für die erfindungsgemäß einzusetzenden Polymeren der Komponente b) kommen zusätzlich zu den beiden vorstehend genannten Comonomer-Gruppen auch N-Vinylamide, wie z. B. N-Vinylformamid, N-Vinylacetamid, N-Vinyl-N-methylacetamid und vorzugsweise N-Vinyllactame, insbesondere N-Vinylpyrrolidon und N-Vinylcaprolactam, in Frage.

Als Beispiele für die in den wäßrig-alkalischen Lösungen löslichen oder dispergierbaren Polymeren, die als Komponente b) in Betracht kommen, seien die Copolymerisate des folgenden Typs genannt, die gegebenenfalls weitere Comonomere einpolymerisiert enthalten können : Styrol/Maleinsäureanhydrid-Copolymerisate, Styrol/Maleinsäurehalbester/Copolymerisate, Styrol/Maleinsäureanhydrid/(Meth)acrylsäure-Copolymerisate, (Meth)acrylsäurealkylester/(Meth)acrylsäure-Copolymerisate, Styrol/(Meth)acrylsäurealkyl-ester/(Meth)acrylsäure-Copolymerisate und ähnliche. Als besonders vorteilhaft für die Komponente b) der erfindungsgemäßen photopolymerisierbaren Resistschichten haben sich solche wäßrig-alkalisch löslichen oder zumindest dispergierbaren Copolymerisate erwiesen, die N-Vinylamide als Co-Baustein einpolymerisiert enthalten. Hierzu gehören insbesondere die Copolymerisate, die ein oder mehrere N-Vinylamide, insbesondere der weiter oben genannten Art, ferner Acrylsäure und/oder Methacrylsäure sowie darüber hinaus ein oder mehrere hydrophobe Vinyl-Monomere, die als solche in Wasser oder wäßrig-alkalischen Lösungen unlösliche Homopolymerisate bilden, wie sie ebenfalls weiter oben angeführt sind, einpolymerisiert enthalten. Bevorzugte Copolymerisate dieser Art enthalten N-Vinyllactame, wie N-Vinylpyrrolidon oder N-Vinylcaprolactam, Acrylsäure und/oder Methacrylsäure sowie als weitere, hydrophobe Comonomere, gegebenenfalls substituierte Styrole und/oder (Meth)acrylsäurealkylester, insbesondere Styrol selbst und/oder Methylmethacrylat, einpolymerisiert. Die geeigneten N-Vinylamid-Copolymerisate enthalten dabei im allgemeinen 10 bis 50 Gew.%, vorzugsweise 20 bis 45 Gew.% der N-Vinylamide, 5 bis 30 Gew.%, insbesondere 5 bis 15 Gew.% an Acryl- und/oder Methacrylsäure sowie 30 bis 80 Gew.%, vorzugsweise 40 bis 70 Gew.% der weiteren hydrophoben Vinyl-Monomeren einpolymerisiert, wobei sich die gemachten Prozentangaben jeweils auf das Copolymerisat beziehen.

Die als Komponente b) der erfindungsgemäßen photopolymerisierbaren Resistschichten einzusetzenden Polymeren können nach den an sich bekannten und üblichen Polymerisationsmethoden hergestellt werden.

Neben den Oligomeren (Komponente a)) und den filmbildenden Polymeren (Komponente b)) enthalten die erfindungsgemäßen photopolymerisierbaren Resistschichten als Komponente c) 1 bis 30 Gew.%, insbesondere 10 bis 25 Gew.%, bezogen auf die die photopolymerisierbare Resistschicht bildende Mischung, mindestens eines photopolymerisierbaren Monomeren. Diese Monomeren, die üblicherweise einen Siedepunkt bei Atmosphärendruck von über 100 °C aufweisen, haben im allgemeinen ein Molekulargewicht unter 10 000. Die photopolymerisierbaren Monomeren, die allein oder in Mischung miteinander eingesetzt werden können, können dabei sowohl mono- als auch polyfunktionell sein, d. h. sie können eine oder mehrere photopolymerisierbare ethylenische Doppelbindungen besitzen. Vorteilhafterweise sind in der erfindungsgemäßen photopolymerisierbaren Resistschicht als Komponente c) Monomere mit zwei oder mehr photopolymerisierbaren ethylenischen Doppelbindungen enthalten. Diese bi- oder mehrfunktionellen Monomeren können dabei allein, in Mischung miteinander oder in Mischung mit monofunktionellen Monomeren, d. h. Monomeren mit nur einer photopolymerisierbaren ethylenischen Doppelbindung, eingesetzt werden. Vorzugsweise kommen solche Monomeren zur Anwendung, die mindestens eine endständige Vinyl- oder Vinyliden-Doppelbindung aufweisen, und insbesondere solche, bei denen die photopolymerisierbare Doppelbindung bzw. die photopolymerisierbaren Doppelbindungen durch Konjugation oder durch Nachbarschaftsstellung zu O-, N- oder S-Atomen aktiviert sind.

Als Vertreter für die Photopolymerisierbaren Monomeren seien neben den Allylverbindungen, wie z. B. Allylacrylat und Diallylphthalat, und Vinylverbindungen, wie z. B. N-Vinyllactamen und insbesondere N-Vinylpyrrolidon oder N-Vinylcaprolactam, vornehmlich die Acryloyl- und/oder Methacryloyl-Gruppen enthaltenden Monomeren genannt. Hierzu gehören insbesondere die Ester der Acrylsäure und Methacrylsäure, wie z. B. die Di- und Tri(meth)acrylate etwa von Ethylenglykol, Diethylenglykol, Triethylenglykol oder Polyethylenglykolen mit einem Molekulargewicht bis etwa 500, 1,2-Propandiol, 1,3-Propandiol, Polypropylenglykolen mit einem Molekulargewicht bis etwa 500, 1,4-Butandiol, 1,1,1-Trimethylolpropan, 2,2-Dimethylpropandiol, Glycerin oder Pentaerythrit ; Pentaerythrittetra-(meth)acrylat, Glukosetetra-(meth)acrylat ; Urethanacrylate und -methacrylate mit 2 oder mehr Acryloyl- bzw. Methacryloyl-Gruppen, wie sie beispielsweise durch Umsetzung von aliphatischen Diolen oder Polyolen der vorstehend genannten Art mit organischen Diisocyanaten, z. B. Hexamethylendiisocyanat, im Äquivalentverhältnis OH : NCO von etwa 1 : 2 und anschließende Umsetzung der freien Isocyanatgruppen mit Monohydroxy-(meth)acrylaten, insbesondere Hydroxyalkyl-(meth)acrylaten hergestellt werden können ; Methacrylsäureester mit zwei oder mehr Acryloyl- und/oder Methacryloyl-Gruppen, wie sie durch Umsetzung von Acrylsäure und/oder Methacrylsäure mit Di- oder Polyglycidylverbindungen, insbesondere Di- oder Polyglycidylethern, erhalten werden können, wie z. B. das Umsetzungsprodukt aus 2 Mol Acrylsäure und/oder Methacrylsäure mit einem Mol Bisphenol A-bis-glycidylether. Als Beispiel für monofunktionelle Monomere seien die Monoacrylate und Monomethacrylate von Monoalkanolen, insbesondere mit 1 bis 20 C-Atomen, oder der oben genannten Diole und Polyole erwähnt. Zu den besonders bevorzugten Monomeren gehören unter anderem Trimethylolpropantriacrylat, Trimethylolpropantrimethacrylat, Pentaerythrittri- und -tetraacrylat sowie Pentaerythrittri- und -tetramethacrylat.

Als Komponente d) ist in der erfindungsgemäßen photopolymerisierbaren Resistschicht mindestens ein Photopolymerisationsinitiator enthalten. Hierfür kommen insbesondere die für die Herstellung von photopolymerisierbaren Resistschichten bekannten und üblichen Photoinitiatoren bzw. Photoinitiatorsysteme in Betracht. Dazu gehören Benzoin und Benzoinderivate, wie Benzoinether ; substituierte Benzoine und substituierte Benzoinderivate, z. B. substituierte Benzoinether ; Benzile, insbesondere Benzilketale, wie z. B. Benzyldimethylketal, Benzilmethylethylketal oder Benzilmethylbenzylketal ; und die als Photoinitiatoren bekannten und wirksamen Benzoyldiarylphosphinoxide. Besonders vorteilhaft als Photopolymerisationsinitiator sind Verbindungen vom Typ des Benzophenons und seiner Derivate, wie Benzophenon, 4,4'-Dimethylaminobenzophenon, 4,4'-Diethylaminobenzophenon, Derivate von Michler's Keton, 4,4'-Dichlorbenzophenon etc., sowie deren Gemische, insbesondere Mischungen aus Benzophenon und Michler's Keton ; Hexaarylbisimidazole, wie z. B. 2,2'-o-Chlorphenyl-4,4',5,5'-p-methoxyphenyl-bisimidazol, oder Gemische aus Hexaarylbisimidazolen mit Sensibilisierungsmitteln, wie z. B. 2-Mercaptobenzochinazol ; mehrkernige unsubstituierte oder substituierte Chinone, wie Anthrachinon, Benzanthrachinon, 2-Ethylanthrachinon oder tert.-Butylanthrachinon ; sowie die als Photoinitiatoren wirksamen Acridin- oder Phenacin-Derivate. Typische Beispiele für Photoinitiatorsysteme sind Kombinationen aus Benzophenon oder Benzophenon-Derivaten mit tertiären Aminen, wie Triethanolamin oder Michler's Keton, oder Gemische aus Hexaarylbisimidazolen und Triphenylmethan-Leukofarbstoffen, wie z. B. Leukokristallviolett, Leukomalachitgrün oder Tris-(4-diethylamino-2-methylphenyl)-methan. Die Auswahl der geeigneten Photoinitiatoren bzw. Photoinitiator-Systeme ist dem Fachmann geläufig. Die Photoinitiatoren können allein oder in Mischung miteinander eingesetzt werden und sind in der erfindungsgemäßen photopolymerisierbaren Resistschicht in Mengen von 0,001 bis 10 Gew.%, insbesondere in Mengen von 0,1 bis 5 Gew.%, bezogen auf die photopolymerisierbare Resistschicht, enthalten.

Neben den Komponenten a) bis d) können in der erfindungsgemäßen photopolymerisierbaren Resistschicht gegebenenfalls als Komponente e), weitere, die verarbeitungs- und/oder anwendungstechnischen Eigenschaften der Resistschicht verbessernde und/oder modifizierende Zusatz- und/oder Hilfsstoffe enthalten sein. Hierzu gehören, u. a. thermische Polymerisationsinhibitoren, wie z. B. Hydrochinon, Hydrochinon-Derivate, 2,6-Ditert.-butyl-p-kresol, Nitrophenole, N-Nitrosoamine, wie N-Nitrosodiphenylamin oder die Salze des N-Nitrosocyclohexylhydroxylamins ; Farbstoffe und/oder Pigmente, die sowohl als Kontrastmittel als auch schichtverfestigend wirken können, wie z. B. Brilliant Green Dye (C.I. 42 040) Viktoriareinblau FGA, Viktoria-Reinblau 80 (C. I. 42 595), Viktoria-Blau B (C. I. 44 045), Rhodamin 6 G (C.I. 45 160), 3'-Phenyl-7-dimethylamino-2,2'-spiro-di-(2H-1-benzopyran) ; photochrome Verbindungen oder photochrome Systeme, die unter dem Einfluß von aktinischem Licht ihre Farbe reversibel oder irreversibel ändern, wie z. B. die Leukobasen der Triarylmethan-Farbstoffe, etwa Malachitgrün-Leukobase oder Kristallviolett-Leukobase, oder auch Rhodamin B-Base zusammen mit einem geeigneten Aktivator, z. B. einer organischen unter dem Einfluß von aktinischem Licht Halogen-Radikale abspaltenden Verbindung oder Hexaaryl-bisimidazolen. Weiterhin können in der photopolymerisierbaren Resistschicht sensitometrische Regler enthalten sein, wie z. B. 9-Nitroanthracen, 10,10'-Bisanthrone, Phenazinium-, Phenoxazinium-, Acridinium- oder Phenothiazinium-Farbstoffe, insbesondere in Kombination mit milden Reduktionsmitteln, 1,3-Dinitrobenzole und ähnliche, sowie Füllstoffe, Verstärkungsmittel oder weitere, die mechanischen Eigenschaften verbessernde Zusatzstoffe. Ferner können in der photopolymerisierbaren Resistschicht auch noch Weichmacher enthalten sein, jedoch ist aufgrund der Zusammensetzung der erfindungsgemäßen photopolymerisierbaren Resistschicht ein solcher gesonderter Zusatz an Weichmachern nicht notwendig und daher im allgemeinen nicht zweckmäßig. Sofern zusätzliche Weichmacher in geringer Menge eingesetzt werden, kommen hierfür beispielsweise die an sich bekannten und verträglichen Weichmacher in Betracht. Die weiteren Zusatz- und/oder Hilfsstoffe (Komponente e) sind in der photopolymerisierbaren Resistschicht in den für diese Verbindungen an sich üblichen, wirksamen Mengen enthalten. Ihr Anteil beträgt dabei insgesamt nicht mehr als 30 Gew.% und liegt vorzugsweise im Bereich von 0,05 bis 12 Gew.%, bezogen auf die photopolymerisierbare Resistschicht.

Neben der Art der Verbindungen für die einzelnen Komponenten der erfindungsgemäßen photopolymerisierbaren Resistschicht sind auch die Mengen, in denen diese in der Resistschicht vorhanden sind, von Bedeutung. Es hat sich nämlich gezeigt, daß die gewünschten ausgewogenen und geforderten Eigenschaften des Trockenfilmresists bzw. der hieraus hergestellten Resistmuster nur dann erzielt werden, wenn die einzelnen Komponenten in dem angegebenen, aufeinander abgestimmten Mengenverhältnissen zueinander in der photopolymerisierbaren Resistschicht enthalten sind. Wird beispielsweise der Anteil des Polymeren (Komponente b)) auf 40 Gew.% oder mehr zu Lasten der Oligomeren (Komponente a)) und/oder der Monomeren (Komponente c)) erhöht, wie es bei den bekannten Photoresistschichten im allgemeinen der Fall ist, werden die Belichtungs- und Entwicklungseigenschaften der Resistschicht merklich beeinträchtigt ; so werden beispielsweise die Löslichkeitsdifferenzierung nach der bildmäßigen Belichtung mit aktinischem Licht zwischen belichteten und unbelichteten Bereichen wesentlich verschlechtert und der Entwicklungsspielraum deutlich eingeschränkt, und es kommt bei der Entwicklung des Resistmusters leicht zu Ablösungen von feinen und feinsten Bildelementen bzw. nur zu einer ungenügenden Ausgestaltung der Resistmusters. Sind andererseits keine Polymeren oder nur ein zu geringer Anteil an Polymeren in der Resistschicht enthalten, so ist häufig die photopolymerisierbare Resistschicht nicht oder nur schlecht laminierbar und auf Substrate übertragbar und damit für Trockenfilmresist-Materialien schlecht geeignet ist. Auch hat sich gezeigt, daß in diesen Fällen das erzeugte Resistmuster, d. h. die belichtete Resistschicht, von dem Substrat nicht oder nur sehr schlecht entschichtet (gestrippt) werden kann. Liegt der Anteil der Monomeren (Komponente c)) zu hoch, so wird nicht nur der Belichtungsspielraum deutlich eingeschränkt, sondern es wird auch die Haftung der Resistschicht auf dem Substrat nach der Schichtübertragung nachteilig beeinflußt. Ist hingegen der Monomer-Anteil in der photopolymerisierbaren Resistschicht zu gering, so sind die Lichtempfindlichkeit und auch das Entwicklungsverhalten beeinträchtigt. Die Zusammensetzung der photopolymerisierbaren Resistschicht ist auch bedeutungsvoll für die geforderte Haftungsdifferenzierung bei den Trockenfilmresists.

Als typisches Beispiel für eine sehr vorteilhafte, erfindungsgemäße photopolymerisierbare Resistschicht sei folgende Zusammensetzung genannt :

a) 45 bis 75 Gew.% mindestens eines Acryloyl- und/oder Methacryloyl-Gruppen sowie freie Carboxyl-Gruppen enthaltenden, urethangruppenfreien Oligomeren auf Basis von Di- oder Polyepoxidverbindungen, wie es beispielsweise erhältlich ist durch Umsetzung von Di- und/oder Polyepoxiden mit Acrylsäure und/oder Methacrylsäure und mehrbasischen Carbonsäuren bzw. deren Derivaten, insbesondere deren Anhydriden, nach einer der vorangehend näher beschriebenen Verfahrensweisen,

b) 10 bis 30 Gew.% mindestens eines filmbildenden, in reinem Wasser unlöslichen, in wäßrig-alkalischen Medien jedoch löslichen oder zumindest dispergierbaren Polymeren, insbesondere einem N-Vinyllactam-Copolymerisat,

c) 10 bis 25 Gew.% mindestens eines Tri- und/oder Tetra-(meth)acrylat-Monomeren oder einer Mischung hiervon, mit einem untergeordneten Anteil an mono- und/oder difunktionellen (Meth)acrylat-Monomeren sowie

d), e) zusammen 1 bis 10 Gew.% an Photoinitiator und weiterem Zusatz und/oder Hilfsstoffen, wobei der Anteil des oder der Photoinitiatoren vorzugsweise im Bereich von 0,1 bis 5 Gew.% liegt und die angegebenen Prozente für die einzelnen Komponenten sich stets auf die gesamte photopolymerisierbare Resistschicht beziehen.

Auf der photopolymerisierbaren Resistschicht des erfindungsgemäßen Trockenfilmresists kann gewünschtenfalls noch eine abziehbare Deckfolie aufgebracht sein. Diese Deckfolie, die vorzugsweise aus dünnen Kunststoff-Filmen oder -Folien gebildet wird, wie beispielsweise Polyethylen, Polypropylen oder dergleichen, soll gegenüber der photopolymerisierbaren Resistschicht eine geringere Haftung aufweisen als der temporäre Schichtträger, damit sie vor dem Auflaminieren der photopolymerisierbaren Resistschicht auf das Substrat problemlos von dieser abgezogen werden kann. Die Stärke der Deckfolie liegt im allgemeinen zwischen etwa 20 und 30 $\mu$m.

Der erfindungsgemäße Trockenfilmresist kann in an sich üblicher und bekannter Weise hergestellt werden, indem eine homogene Mischung der die photopolymerisierbare Resistschicht bildenden Komponenten schichtförmig auf den temporären Schichtträger aufgebracht wird und anschließend diese photopolymerisierbare Resistschicht gegebenenfalls mit der Deckfolie versehen wird. Das Aufbringen der photopolymerisierbaren Resistschicht auf den temporären Schichtträger erfolgt vorteilhafterweise durch Gießen aus Lösung und Verdampfen des Lösungsmittels oder nach jeder anderen bekannten und geeigneten Verfahrensweise. Vorteilhafte Lösungsmittel sind hierfür unter anderem niedere Alkanole, Ketone oder Ester, wie z. B. Methanol, Aceton, Methylethylketon, Essigsäureethylester und ähnliche.

Zur Herstellung der Resistmuster wird der erfindungsgemäß zusammengesetzte photopolymerisierbare Resistschicht auf das zu schützende, sowie gegebenenfalls dauerhaft zu modifizierende Substrat aufgebracht. Als Substrat, dessen Art sich bekanntermaßen nach dem jeweiligen Anwendungszweck des herzustellenden Resistmusters richtet, kommen die in diesem Bereich üblichen und bekannten Materialien in Betracht. So werden beispielsweise für die Herstellung von Ätz- oder Galvano-Resists, wie sie etwa bei der Fertigung von Leiterplatten oder gedruckten Schaltungen benötigt werden, als Substrate Kupferbleche oder kupferkaschierte Basismaterialien verwendet. Für die Herstellung von Dünnschichtschaltungen oder Mehrschichtschaltungen werden insbesondere Keramiksubstrate, die mit metallischen oder metalloxidischen Schichten beschichtet sind, oder Halbleiterelemente verarbeitet. In der Halbleitertechnik dienen als Substrate häufig Silizium-, GaAs- oder Ge-Wafer, die oberflächlich mit einer Oxidschicht oder allgemeinen Isolierschicht versehen sein können. Für die Herstellung von permanenten, bildmäßig strukturierten Schutz- oder Isolierschichten, insbesondere Lötstoppmasken, werden die photopolymerisierbaren Resistschichten z. B. auf das Schaltbild einer gedruckten Schaltung oder eine mit Bohrlöchern versehene Leiterplatte aufgebracht. Die erfindungsgemäß zusammengesetzten, photopolymerisierbaren Resistschichten zeichnen sich dabei durch eine sehr gute Haftung gegenuber den üblicherweise verwendeten Substraten, insbesondere solchen mit metallischen oder metalloxidischen Oberflächen, aus.

Auch wenn die erfindungsgemäß zusammengesetzte photopolymerisierbare Resistschicht auf das Substrat nach jeder üblichen und an sich bekannten Auftragstechnik aufgebracht werden kann, wie z. B. durch Gießen aus Lösung, Tauchbeschichtung, Lippengießen, Spin-coating etc., so geschieht dieses Aufbringen in aller Regel doch in sehr günstiger und vorteilhafter Weise durch Schichtübertragung mittels des erfindungsgemäßen Trockenfilmresists. Hierbei wird eine gegebenenfalls vorhandene Deckfolie zunächst abgezogen und dann die freie Oberfläche der photopolymerisierbaren Resistschicht des Trockenfilmresists unter Anwendung von Druck sowie gegebenenfalls Wärme auf die Oberfläche des Substrats auflaminiert bzw. aufkaschiert. Dabei ist es möglich, die photopolymerisierbare Resistschicht vor dem Aufbringen auf das Substrat von der dem temporären Schichtträger abgewandten Oberfläche her, d. h. also von der Seite her, die auf das Substrat auflaminiert bzw. aufkaschiert wird, kurzzeitig vollflächig mit aktinischem Licht vorzubelichten. Hierdurch wird eine Verkürzung der nachfolgenden bildmäßigen Hauptbelichtung der Resistschicht ermöglicht, ohne daß durch die vollflächige Vorbelichtung die bildmäßige Differenzierung und Strukturierung der Resistschicht nachteilig beeinflußt wird. Eine solche Vorbelichtung hat sich insbesondere dann als vorteilhaft erwiesen, wenn Trockenfilmresists mit relativ dicken photopolymerisierbaren Resistschichten eingesetzt werden, da in diesen Fällen sonst vergleichsweise lange Belichtungszeiten erforderlich wären. Nach dem Auflaminieren bzw. Aufkaschieren der photopolymerisierbaren Resistschicht auf das Substrat wird der temporäre Schichtträger des Trockenfilmresists — wahlweise vor oder nach der bildmäßigen Belichtung — von der Resistschicht abgezogen. Vorzugsweise erfolgt das Abziehen des temporären Schichtträgers vor der bildmäßigen Belichtung der photopolymerisierbaren Resistschicht.

Nach dem Aufbringen der photopolymerisierbaren Resistschicht auf das Substrat wird die Resistschicht zur Erzeugung des gewünschten Resistmusters bildmäßig mit aktinischem Licht belichtet. Die Wellenlänge des verwendeten aktinischen Lichts wird vorteilhafterweise auf die Eigenabsorption des in der photopolymerisierbaren Schicht enthaltenen Photopolymerisationsinitiators abgestimmt. Üblicherweise liegt die Wellenlänge des für die bildmäßige Belichtung verwendeten aktinischen Lichtes im Bereich von etwa 300 bis 420 nm. Als Strahlungsquellen für das aktinische Licht kommen die üblichen und an sich bekannten Lichtquellen in Betracht, wie z. B. Kohlebogenlampen, Quecksilberhoch-, -mittel- oder -niederdruckstrahler, Xenonhochdrucklampen, UV-Fluoreszenzröhren, superaktinische Leuchtstofröhren, Quecksilberniederdruckfluoreszenzlampen etc. oder auch UV-Laser, die in dem aktinischen Wellenlängenbereich emittieren. Die bildmäßige Belichtung der Resistschicht kann mittels eines bildmäßig modulierten Laserstrahls erfolgen oder bei Verwendung von diffusem Licht unter Einsatz einer geeigneten, beispielsweise photographischen, Bildvorlage, etwa eines photographischen Negativs oder Positivs, deren Opak-Bereiche für die verwendete aktinische Strahlung praktisch undurchlässig sind.

Die Dauer für die bildmäßige Belichtung hängt neben der Zusammensetzung der photopolymerisierbaren Resistschicht unter anderem auch von deren Dicke und der Strahlungsintensität ab. Üblicherweise liegt die Zeit für die bildmäßige Belichtung im Bereich von 5 bis 15 sec, wobei die optimalen Belichtungsbedingungen in bekannter Weise anhand von einfachen Vorversuchen leicht festgestellt werden können. Wird die photopolymerisierbare Resistschicht vor dem Auflaminieren bzw. Aufkaschieren auf das Substrat, wie oben erwähnt, kurzzeitig vollflächig vorbelichtet, so kann die Dauer für diese Vorbelichtung bis etwa 70 % der Dauer für die bildmäßige Hauptbelichtung betragen. Vollflächige Vorbelichtung und bildmäßige Hauptbelichtung können dabei mit der gleichen oder auch mit verschiedenen Strahlungsquellen vorgenommen werden.

Nach der bildmäßigen Belichtung der Resistschicht werden die unbelichteten Schichtanteile mit einem wäßrigen Entwicklerlösungsmittel in üblicher Weise, beispielsweise durch Besprühen, Auswaschen, Ausreiben oder Ausbürsten mit dem Entwicklerlösungsmittel, entfernt. Als wäßrige Entwicklerlösungsmittel können — je nach Zusammensetzung der photopolymerisierbaren Resistschicht — z. B. Wasser oder Wasser/Alkohol-Mischungen, die eine überwiegende Menge an Wasser enthalten, eingesetzt werden, insbesondere kommen aber wäßrig-alkalische Entwicklerlösungen in Betracht, die zur Einstellung des günstigsten pH-Wertes, im allgemeinen im Bereich von etwa 8 bis 14 und vorzugsweise im Bereich von 9 bis 13, alkalisch reagierende Substanzen, wie z. B. Borax, Dinatriumhydrogenphosphat, Soda, Alkalihydroxide oder organische Basen, wie Di- oder Triethanolamin, in Wasser gelöst enthalten. Die wäßrig-alkalischen Entwicklerlösungen können ferner übliche Puffersalze, z. B. wasserlösliche Alkaliphosphate, -silikate, -borate, -acetate oder -benzoate enthalten. Als weitere Bestandteile dieser Entwicklerlösungen können Netzmittel, vorzugsweise anionische Netzmittel, und gegebenenfalls wasserlösliche Polymere, wie z. B. Natriumcarboxymethylcellulose, Polyvinylalkohol, Polynatriumacrylat und dergleichen, mitverwendet werden. Wenn auch nicht nötig, so ist es ferner doch möglich, daß die wäßrig-alkalischen Entwicklerlösungen auch geringe Zusätze von wasserlöslichen, organischen Lösungsmitteln, wie z. B. aliphatischen Alkoholen, Aceton oder Tetrahydrofuran, enthalten. Nach dem Entwickeln wird das erhaltene Resistmuster im allgemeinen von den Resten des Entwicklerlösungsmittels befreit und getrocknet.

Die erfindungsgemäßen Resistschichten zeichnen sich dabei nicht nur durch sehr gute Belichtungseigenschaften, sondern insbesondere auch durch einen großen Entwicklungsspielraum und die hohe Beständigkeit der belichteten Schichtanteile gegenüber den wäßrigen Entwicklerlösungsmitteln aus. So können Resistmuster mit sehr feinen Linien und Strukturen vorlagengetreu und exakt reproduziert werden, ohne daß es beispielsweise zur Ablösung von feinen Bildelementen kommt. Die durch die Entwicklung des Resistmusters freigelegten Bereiche des Substrats können anschließend in an sich bekannter Weise, beispielsweise durch Metallabscheidung, Ätzen oder Dotieren, dauerhaft modifiziert werden. Auch gegenüber den hierbei verwendeten Prozeßchemikalien, insbesondere den Galvanisier- und/oder Ätzbädern, zeichnet sich der erfindungsgemäße Resist durch hohe Beständigkeit aus. Nach der dauerhaften Modifizierung des Substrats kann das Resistmuster gewünschtenfalls durch Entschichten (Strippen) mit einem geeigneten Lösungsmittel von dem Substrat entfernt werden. Das Resistmuster kann aber auch als permanente Schutz- bzw. Isolierschicht auf dem Substrat verbleiben. Der erfindungsgemäße Trockenfilmresist und das erfindungsgemäße Verfahren zur Herstellung von Resistmustern eignen sich für alle Anwendungszwecke, die für bildmäßig strukturierte Resistschichten bekannt sind, wie z. B. als Ätz- und Galvanoresist bei der Herstellung von Leiterplatten, gedruckten Schaltungen, für die Herstellung von Dünnschicht- oder Mehrschichtschaltungen etc.

Die Erfindung wird durch die nachfolgenden Beispiele näher erläutert. Die in den Beispielen genannten Teile und Prozente beziehen sich, sofern nicht anders angegeben, auf das Gewicht.

I. Synthese der Oligomeren

Synthesebeispiel 1

Der aus Bisphenol A und Epichlorhydrin hergestellte Bisphenol A-diglycidylether wurde mit Adipinsäure und Acrylsäure im Molverhältnis 2 : 1 : 2 zu einem Hydroxylgruppen und Acryloyl-Gruppen enthaltenden Harz mit einem OH-Äquivalentgewicht von 270 umgesetzt. Zu einer Lösung von 386 Teilen dieses hydroxylgruppenhaltigen Ausgangsharzes (70 %ig in Ethylacetat) wurden 148 Teile Phthalsäureanhydrid (1 Äquivalent), 2,5 Teile Dimethylaminopyridin, 1 Teil Di-t.-butyl-p-kresol und 84 Teile Ethylacetat zugegeben, anschließend das Reaktionsgemisch auf 80 °C aufgeheizt und 5 Stunden bei dieser Temperatur gehalten. Zu der Lösung des erhaltenen Reaktionsprodukts wurden danach 40 Teile Pentaerythrittriglycidylether und weitere 2,5 Teile Dimethylaminopyridin zugesetzt. Anschließend wurde die Reaktion weitere 5 Stunden bei 80 °C geführt. Danach wurde auf Raumtemperatur abgekühlt und mit weiteren 259 Teilen Ethylacetat verdünnt.

Der Feststoffgehalt der auf diese Weise hergestellten Harzlösung betrug 46 %. Das Acryloylgruppen enthaltende oligomere Harz hatte eine Säurezahl von 119 mg KOH/g und war in 1 % wäßriger Soda-Lösung löslich.

### Synthesebeispiel 2

In einem Reaktionskessel wurden 500 Teile des in Synthesebeispiel 1 hergestellten hydroxylgruppenhaltigen Ausgangsharzes (70 %ig in Ethylacetat), 172,6 Teile Phthalsäureanhydrid, 1,3 Teile Di-t.-butyl-p-kresol, 3,2 Teile Dimethylaminopyridin und 74 Teile Ethylacetat vorgelegt, die Mischung aufgeheizt und 4 Stunden bei 77 °C gehalten. Anschließend wurden zu der erhaltenen Reaktionslösung 81,3 Teile des Diglycidylethers aus Epichlorhydrin und Bisphenol A, 2,9 Teile Dimethylaminopyridin und 120 Teile Ethylacetat zugegeben und wurde die Reaktion weitere 5 Stunden bei 77 °C geführt. Danach wurde auf Raumtemperatur abgekühlt und mit 260 Teilen Ethylacetat verdünnt.

Der Feststoffgehalt der auf diese Weise erhaltenen Harzlösung betrug ca. 50 %. Das oligomere, in 1 %iger wäßriger Sodalösung lösliche Harz hatte eine Säurezahl von 97 mg KOH/g.

### II. Herstellung der Photoresists

### Beispiel 1

Unter Rühren wurde eine homogene Lösung mit folgenden Bestandteilen hergestellt :

54,7 % des gemäß Synthesebeispiel 1 hergestellten Oligomeren (46 % in Ethylacetat),
20 % eines Copolymerisats aus 66 % N-Vinylpyrrolidon und 34 % Vinylpropionat mit einem K-Wert (nach Fikentscher) von 49,9 (46 %ig in tert.-Butanol),
18 % Trimethylolpropantriacrylat
3,5 % Benzophenon
0,15 % Michler's Keton
3 % 2,5-Dichlor-1,4-bis(dichlormethyl)benzol
0,5 % Kristallviolett-Leukobase
0,05 % Sicomet-Patentblau 80 E 131
0,1 % Di-t.-butyl-p-Kresol

Die Lösung wurde durch ein Druckfilter filtriert und dann in solcher Schichtstärke auf eine 23 μm dicke Polyethylenterephthalat-Folie gegossen, daß nach dem Ablüften der Lösungsmittel und Trocknen (3 min bei 80 °C) eine Trockenfilmdicke von 35 μm resultierte. Die photopolymerisierbare Resistschicht wurde bis zur Weiterverarbeitung des so erhaltenen Trockenfilmresists mit einer 23 μm dicken Polyethylen-Folie abgedeckt.

Für die Herstellung eines Resistmusters wurde die Polyethylen-Folie des Trockenfilmresists abgezogen und die photopolymerisierbare Resistschicht bei 80 bis 120 °C auf ein kupferkaschiertes Leiterplatten-Substrat auflaminiert, durch ein photographisches Negativ bildmäßig mit aktinischem Licht belichtet und nach Abziehen der Polyethylenterephthalat-Trägerfolie mit 1 %iger wäßriger Sodalösung ausgewaschen. Das entwickelte Resistmuster wurde anschließend getrocknet. Die freigelegten Bereiche der Kupferoberfläche wurden in marktüblichen Ätz- bzw. Galvanikbädern geätzt bzw. galvanisiert. Dabei ergaben sich in ammoniakalischen bzw. sauren Ätzbädern gute bis sehr gute Ätzstrukturen. In den sauren Galvanikbädern wurde bei langen Prozeßzeiten eine geringe Extraktion des wasserlöslichen Polymeren in den Galvanik-Elektrolyten beobachtet wodurch es nach längerer Zeit zu einer Störung bei der Metallabscheidung kommen kann.

### Beispiel 2

Es wurde wie in Beispiel 1 gearbeitet, jedoch mit dem Unterschied, daß anstelle des Oligomeren von Synthesebeispiel 1 diesmal 50,7 % des Oligomeren von Synthesebeispiel 2 (etwa 50 %ig in Ethylaceat) sowie zusätzlich 4 % p-Hydroxylbenzoesäure-2-ethylhexylester eingesetzt und das N-Vinylpyrrolidon/Vinylpropionat-Copolymerisat durch die gleiche Menge eines Copolymerisats aus 60 % Methylmethacrylat, 30 % N-Vinylpyrrolidon und 10 % Methacrylsäure (28 %ig in Methanol ; K-Wert : 40) ersetzt wurden. Die mit diesen Photoresistfilmen hergestellten Resistmuster konnten in allen Ätz- und Galvanikbädern problemlos verarbeitet werden und lieferten sehr gute Ergebnisse.

**Patentansprüche**

1. Trockenfilmresist mit einer auf einem temporären, dimensionsstabilen Träger aufgebrachten, festen, übertragbaren wäßrig entwickelbaren, photopolymerisierbaren Resistschicht sowie gegebenenfalls einer abziehbaren Deckfolie auf der Resistschicht, dadurch gekennzeichnet, daß die photopolymerisierbare Resistschicht gebildet wird aus einer homogenen Mischung von

a) mindestens 40 Gew.% mindestens eines photopolymerisierbaren, in wäßrig-alkalischen Lösungen löslichen oder zumindest dispergierbaren, freie Carboxylgruppen und mehr als zwei Acryloyl- und/oder Methacryloyl-Gruppen enthaltenden Oligomeren mit einem mittleren Molekulargewicht (Zahlenmittel) im Bereich von etwa 1 000 bis etwa 10 000 und einer Säurezahl im Bereich von 50 bis 150 mg KOH/g, erhältlich durch Umsetzung einer Acryloyl- und/oder Methacryloyl-Gruppen enthaltenden Diol- oder Polyol-Verbindung mit dem Anhydrid einer mehrbasischen Carbonsäure, insbesondere cyclischen Carbonsäureanhydriden, unter Veresterung aller oder nur eines Teils der Hydroxylgruppen der Diol- oder Polyolverbindung unter Bildung der sauren Teilester der mehrbasischen Carbonsäure und weitere Umsetzung eines Teils der freien Carboxylgruppen des so erhaltenen Reationsproduktes mit einem Di- oder Polyepoxid unter Kettenverlängerung sowie gegebenenfalls Verzweigung des Produktes ;

b) 1 bis 35 Gew.% mindestens eines filmbildenden, in Wasser oder in wäßrig-alkalischen Lösungen löslichen oder zumindest dispergierbaren, mit den Oligomeren der Komponente a) verträglichen Polymeren mit einem mittleren Molekulargewicht (Gewichtsmittel) größer als etwa 15 000 ;

c) 1 bis 30 Gew.% mindestens eines mit den Oligomeren der Komponente a) und den Polymeren der Komponente b) verträglichen photopolymerisierbaren Monomeren ;

d) 0,001 bis 10 Gew.% mindestens eines Photopolymerisationsinitiators sowie

e) 0 bis 30 Gew.% an weiteren Zusatz- und/oder Hilfsstoffen, wobei die Prozentangaben jeweils auf die gesamte Mischung bezogen sind.

2. Trockenfilmresist nach Anspruch 1, dadurch gekennzeichnet, daß es sich bei der Diol- bzw. Polyol-Verbindung zur Herstellung des oder der Oligomeren für die Komponente a) um ein Diol bzw. Polyol handelt, wie es erhältlich ist durch Umsetzung eines Di- oder Polyepoxides mit einer äquivalenten Menge an Acrylsäure und/oder Methacrylsäure.

3. Trockenfilmresist nach einem der Ansprüche 1 oder 2, dadurch gekennzeichnet, daß die als Komponente a) in der photopolymerisierbaren Resistschicht enthaltenen Oligomeren im Mittel etwa 2,1 bis 8 Acryloyl- und/oder Methacryloyl-Gruppen pro Molekül aufweisen und eine Säurezahl im Bereich von 50 bis 150 besitzen.

4. Trockenfilmresist nach einem der Ansprüche 1 bis 3, dadurch gekennzeichnet, daß die Oligomeren der Komponente a) in der photopolymerisierbaren Resistschicht in einer Menge von mindestens 45 Gew.%, bezogen auf die photopolymerisierbare Resistschicht, enthalten sind.

5. Trockenfilmresist nach einem der Ansprüche 1 bis 4, dadurch gekennzeichnet, daß das oder die Polymeren der Komponente b) in Wasser unlöslich und in wäßrig-alkalischen Lösungen löslich oder zumindest dispergierbar ist bzw. sind.

6. Trockenfilmresist nach einem der Ansprüche 1 bis 5, dadurch gekennzeichnet, daß als Komponente b) ein N-Vynilamid-Polymerisat enthalten ist.

7. Trockenfilmresist nach Anspruch 6, dadurch gekennzeichnet, daß es sich bei den Polymeren der Komponente b) um in Wasser unlösliche, in wäßrig-alkalischen Lösungen jedoch lösliche oder zumindest dispergierbare Copolymerisate aus einem N-Vinyllactam, Acryl- und/oder Methacrylsäure sowie einem mehreren hydrophoben Comonomeren, die als solche wasserunlösliche Homopolymerisate bilden, handelt.

8. Trockenfilmresist nach einem der Ansprüche 1 bis 7, dadurch gekennzeichnet, daß die Polymeren der Komponente b) in der photopolymerisierbaren Resistschicht in einer Menge von 10 bis 30 Gew.%, bezogen auf die photopolymerisierbare Resistschicht, enthalten sind.

9. Trockenfilmresist nach einem der Ansprüche 1 bis 8, dadurch gekennzeichnet, daß als Komponente c) Triacrylat-, Trimethacrylat-, Tetraacrylat- und/oder Tetramethacrylat-Monomere enthalten sind.

10. Trockenfilmresist nach einem der Ansprüche 1 bis 9, dadurch gekennzeichnet, daß die Monomeren der Komponente c) in der photopolymerisierbaren Resistschicht in einer Menge von 10 bis 25 Gew.%, bezogen auf die photopolymerisierbare Resistschicht, enthalten sind.

11. Verfahren zur Herstellung von Resistmustern auf einem Substrat, bei dem auf das Substrat eine feste, photopolymerisierbare, in wäßrigen Entwicklerlösungsmitteln lösliche bzw. dispergierbare Resistschicht aufgebracht, diese bildmäßig mit aktinischem Licht belichtet wird und anschließend die nicht belichteten Bereiche der Resistschicht mit dem Entwicklerlösungsmittel ausgewaschen werden, dadurch gekennzeichnet, daß die photopolymerisierbare Resistschicht gebildet wird aus einer filmbildenden homogenen Mischung von

a) mindestens 40 Gew.% mindestens eines photopolymerisierbaren, in wäßrig-alkalischen Lösungen löslichen oder zumindest dispergierbaren, freie Carboxyl-Gruppen und mehr als zwei Acryloyl- und/oder Methacryloyl-Gruppen enthaltenden Oligomeren mit einem mittleren Molekulargewicht (Zahlenmittel) im Bereich von etwa 1 000 bis 10 000 und einer Säurezahl im Bereich von 50 bis 150 mg KOH/g, erhältlich durch Umsetzung einer Acryloyl- und/oder Methacryloyl-Gruppen enthaltenden Diol- oder Polyol-Verbindung mit dem Anhydrid einer mehrbasischen Carbonsäure, insbesondere cyclischen Carbonsäureanhydriden, unter Veresterung aller oder nur eines Teils der Hydroxylgruppen der Diol- oder Polyolverbindung unter Bildung der sauren Teilester der mehrbasischen Carbonsäure und weitere Umsetzung eines Teils der freien Carboxylgruppen des so erhaltenen Reaktionsproduktes mit einem Di- oder Polyepoxid unter Kettenverlängerung sowie gegebenenfalls Verzweigung des Produktes ;

b) 1 bis 35 Gew.% mindestens eines filmbildenden, in Wasser oder in wäßrig-alkalischen Lösung

## 0 186 091

löslichen oder zumindest dispergierbaren, mit den Oligomeren der Komponente a) verträglichen Polymeren mit einem mittleren Molekulargewicht (Gewichtsmittel) größer als etwa 15 000 ;

c) 1 bis 30 Gew.% mindestens eines mit den Oligomeren der Komponente a) und den Polymeren der Komponente b) verträglichen photopolymerisierbaren Monomeren ;

d) 0,001 bis 10 Gew.% mindestens eines Photopolymerisationsinitiators sowie

e) 0 bis 30 Gew.% an weiteren Zusatz- und/oder Hilfsstoffen, wobei die angegebenen Prozentangaben jeweils auf die gesamte Mischung bezogen sind.

12. Verfahren nach Anspruch 11, dadurch gekennzeichnet, daß auf das Substrat eine vorgefertigte photopolymerisierbare Resistschicht auflaminiert bzw. aufkaschiert wird unter Verwendung eines Trockenfilmresists gemäß einem der Ansprüche 1 bis 10, wobei eine gegebenenfalls vorhandene Deckfolie vor dem Auflaminieren bzw. Aufkaschieren von der photopolymerisierbaren Resistschicht abgezogen wird und der temporäre Träger nach dem Auflaminieren bzw. Aufkaschieren der photopolymerisierbaren Resistschicht auf das Substrat von der Resistschicht — wahlweise vor oder nach der bildmäßigen Belichtung — entfernt wird.

## Claims

1. A dry film resist possessing a solid photopolymerizable resist layer, which can be laminated and developed with an aqueous medium and is applied on a temporary, dimensionally stable base, and, if required, a cover sheet which is present on the resist layer and can be peeled off, wherein the photopolymerizable resist layer is built from a homogenous mixture of

a) not less than 40 % by weight of one or more photopolymerizable oligomers which are soluble or dispersible in aqueous alkaline solutions, contain free carboxyl groups and more than two acryloyl and/or methacryloyl groups and have a mean molecular weight (number average) of from about 1 000 to about 10 000 and an acid number from 50 to 150 mg of KOH/g, obtainable by reacting a diol or polyol compound containing acryloyl and/or methacryloyl groups with an anhydride of a polybasic carboxylic acid, in particular a cyclic carboxylic anhydride, with esterification of all or only some of the hydroxyl groups of the diol or polyol compound to form the acidic partial ester of the polybasic carboxylic acid, and further reacting some of the free carboxyl groups of the resulting reaction product with a di- or polyepoxide with chain extension and, if required, branching of the product,

b) from 1 to 35 % by weight of one or more filmforming polymers which are soluble or dispersible in water or in aqueous alkaline solutions, are compatible with the oligomers of component a) and have a mean molecular weight (weight average) greater than about 15 000,

c) from 1 to 30 % by weight of one or more photopolymerizable monomers which are compatible with the oligomers of component a) and the polymers of component b),

d) from 0.001 to 10 % by weight of one or more photopolymerization initiators and

e) from 0 to 30 % by weight of additives and/or assistants, the percentages in each case being based on the total mixture.

2. A dry film resist as claimed in claim 1, wherein the diol or polyol compound for the preparation of the oligomer or oligomers for component a) is a diol or polyol as obtainable by reacting a di- or polyepoxide with an equivalent amount of acrylic acid and/or methacrylic acid.

3. A dry film resist as claimed in claim 1 or 2, wherein the oligomers present as component a) in the photopolymerizable resist layer have on average from about 2.1 to 8 acryloyl and/or methacryloyl groups per molecule and an acid number of from 50 to 150.

4. A dry film resist as claimed in any of claims 1 to 3, wherein the oligomers of component a) are present in the photopolymerizable resist layer in an amount of not less than 45 % by weight, based on the photopolymerizable resist layer.

5. A dry film resist as claimed in any of claims 1 to 4, wherein the polymer or polymers of component b) is or are insoluble in water and soluble or dispersible in aqueous alkaline solutions.

6. A dry film resist as claimed in any of claims 1 to 5, which contains an N-vinylamide polymer as component b).

7. A dry film resist as claimed in claim 6, wherein the polymer of component b) is a copolymer which is insoluble in water but soluble or dispersible in aqueous alkaline solutions and consists of an N-vinyllactam, acrylic and/or methacrylic acid and one or more hydrophobic comonomers which as such form water-insoluble homopolymers.

8. A dry film resist as claimed in any of claims 1 to 7, wherein the polymers of component b) are present in the photopolymerizable resist layer in an amount of from 10 to 30 % by weight, based on the said resist layer.

9. A dry film resist as claimed in any of claims 1 to 8, which contains, as component c), triacrylate, trimethacrylate, tetraacrylate and/or tetramethacrylate monomers.

10. A dry film resist as claimed in any of claims 1 to 9, wherein the monomers of component c) are present in the photopolymerizable resist layer in an amount of from 10 to 25 % by weight, based on the said resist layer.

11. A process for the production of a resist image on a substrate, comprising applying a solid,

14

photopolymerizable resist layer, which is soluble or dispersible in aqueous developers, onto the substrate, exposing this resist layer imagewise to actinic light and then washing out the unexposed parts of the resist layer with a developer, wherein the photopolymerizable resist layer is built from a filmforming homogeneous mixture of

a) not less than 40 % by weight of one or more photopolymerizable oligomers which are soluble or dispersible in aqueous alkaline solutions, contain free carboxyl groups and more than two acryloyl and/or methacryloyl groups and have a mean molecular weight (number average) of from about 1 000 to 10 000 and an acid number of from 50 to 150 mg of KOH/g, obtainable by reacting a diol or polyol compound containing acryloyl and/or methacryloyl groups with an anhydride of a polybasic carboxylic acid, in particular a cyclic carboxylic anhydride, with esterification of all or only some of the hydroxyl groups of the diol or polyol compound to form the acidic partial ester of the polybasic carboxylic acid, and further reacting some of the free carboxyl groups of the resulting reaction product with a di- or polyepoxide with chain extension and, if required, branching of the product,

b) from 1 to 35 % by weight of one or more filmforming polymers which are soluble or dispersible in water or in aqueous alkaline solutions, are compatible with the oligomers of component a) and have a mean molecular weight (weight average) greater than about 15 000,

c) from 1 to 30 % by weight of one or more photopolymerizable monomers which are compatible with the oligomers of component a) and the polymers of component b),

d) from 0.001 to 10 % by weight of one or more photopolymerization initiators and

e) from 0 to 30 % by weight of additives and/or assistants, the percentages in each case being based on the total mixture.

12. A process as claimed in claim 11, wherein a prepared photopolymerizable resist layer is laminated onto the substrate, using a dry film resist as claimed in any of claims 1 to 10, any cover sheet present being peeled off from the photopolymerizable resist layer prior to lamination, and the temporary base being removed from the resist layer after lamination of the photopolymerizable resist layer onto the substrate and either before or after the imagewise exposure.


**Revendications**

1. Film formant réserve pour application à sec comprenant une couche de réserve photopolymérisable solide transférable, développable en milieu aqueux, appliquée sur un support temporaire à dimensions stables, et le cas échéant une feuille de couverture éliminable sur la couche de réserve, caractérisé en ce que la couche de réserve photopolymérisable est formée à partir d'un mélange homogène de :

a) au moins 40 % en poids d'au moins un oligomère photopolymérisable, soluble ou au moins dispersable dans les solutions aqueuses alcalines, contenant des groupes carboxyle libres et plus de deux groupes acryloyle et/ou méthacryloyle, ayant un poids moléculaire moyen (moyenne en nombre) dans l'intervalle d'environ 1 000 à 10 000 et un indice d'acide dans l'intervalle de 50 à 150 mg de KOH/g, qu'on peut obtenir en faisant réagir un dérivé de diol ou polyol contenant des groupes acryloyle et/ou méthacryloyle avec l'anhydride d'un acide carboxylique polybasique, en particulier un anhydride d'acide carboxylique cyclique, avec estérification de la totalité ou d'une partie seulement des groupes hydroxy du dérivé de diol ou polyol et formation d'esters partiels acides de l'acide carboxylique polybasique puis en faisant réagir une partie des groupes carboxyle libres du produit de réaction ainsi obtenu avec un di- ou poly-époxyde, avec allongement des chaînes et le cas échéant ramification du produit ;

b) 1 à 35 % en poids d'au moins un polymère filmogène, soluble ou au moins dispersable dans l'eau ou les solutions aqueuses alcalines, compatible avec les oligomères du composant a), ayant un poids moléculaire moyen (moyenne en poids) supérieur à 15 000 environ ;

c) 1 à 30 % en poids d'au moins, un monomère photopolymérisable compatible avec les oligomères du composant a) et les polymères du composant b) ;

d) 0,001 à 10 % en poids d'au moins un inducteur de photopolymérisation et

e) 0 à 30 % en poids d'autres additifs et/ou produits auxiliaires, les indications de pourcentage données se rapportant dans chaque cas au mélange total.

2. Film formant réserve pour application à sec selon la revendication 1, caractérisé en ce que le dérivé de diol ou de polyol utilisé pour la préparation du ou des oligomères du composant a) est un diol ou polyol tel qu'on peut en obtenir en faisant réagir un di- ou poly-époxyde avec une quantité équivalente d'acide acrylique et/ou méthacrylique.

3. Film formant réserve pour application à sec selon l'une des revendications 1 ou 2, caractérisé en ce que les oligomères contenus en tant que composant a) dans la couche de réserve photopolymérisable contiennent en moyenne d'environ 2,1 à 8 groupes acryloyle et/ou méthacryloyle par molécule et ont un indice d'acide se situant dans l'intervalle de 50 à 150.

4. Film formant réserve pour application à sec selon l'une des revendications 1 à 3, caractérisé en ce que les oligomères du composant a) sont contenus dans la couche de réserve photopolymérisable en quantité d'au moins 45 % en poids, par rapport à la couche de réserve photopolymérisable.

5. Film formant réserve pour application à sec selon l'une des revendications 1 à 4, caractérisé en ce que le ou les polymères du composant b) est ou sont insolubles dans l'eau et solubles ou au moins dispersables dans les solutions aqueuses alcalines.

6. Film formant réserve pour application à sec selon l'une des revendications 1 à 5, caractérisé en ce qu'il contient en tant que composant b) un polymère d'un N-vinylamide.

7. Film formant réserve pour application à sec selon la revendication 6, caractérisé en ce que les polymères du composant b) sont des copolymères insolubles dans l'eau mais solubles ou au moins dispersables dans les solutions aqueuses alcalines, d'un N-vinyl-lactame, de l'acide acrylique et/ou méthacrylique et d'un ou plusieurs comonomères hydrophobes donnant par eux-mêmes des homopolymères insolubles dans l'eau.

8. Film formant réserve pour application à sec selon l'un des revendications 1 à 7, caractérisé en ce que les polymères du composant b) sont contenus dans la couche de réserve photopolymérisable en quantité de 10 à 30 % en poids, par rapport à la couche de réserve photopolymérisable.

9. Film formant réserve pour application à sec selon l'une des revendications 1 à 8, caractérisé en ce qu'il contient en tant que composant c) des triacrylates, triméthacrylates, tétra-acrylates et/ou tétraméthacrylates monomères.

10. Film formant réserve pour application à sec selon l'une des revendications 1 à 9, caractérisé en ce que les monomères du composant c) sont contenus dans la couche de réserve photopolymérisable en quantité de 10 à 25 % en poids, par rapport à la couche de réserve photopolymérisable.

11. Procédé pour réaliser des patrons de réserve sur un support, dans lequel on applique sur le support une couche de réserve solide photopolymérisable, soluble ou selon le cas dispersable dans des solvants révélateurs aqueux, on expose cette couche à de la lumière actinique formant une image puis on élimine les zones non exposées de la couche de réserve par lavage avec le solvant révélateur, caractérisé en ce que la couche de réserve photopolymérisable est formée à partir d'un mélange filmogène homogène de :

a) au moins 40 % en poids d'au moins un oligomère photopolymérisable, soluble ou au moins dispersable dans les solutions aqueuses alcalines, contenant des groupes carboxyles libres et plus de deux groupes acryloyle et/ou méthacryloyle, ayant un poids moléculaire moyen (moyenne en nombre) dans l'intervalle d'environ 1 000 à 10 000 et un indice d'acide dans l'intervalle de 50 à 150 mg de KOH/g, qu'on peut obtenir en faisant réagir un dérivé de diol ou polyl contenant des groupes acryloyle et/ou méthacryloyle avec l'anhydride d'un acide carboxylique polybasique, en particulier un anhydride d'acide carboxylique cyclique, avec estérification de la totalité ou d'une partie seulement des groupes hydroxy du dérivé de diol ou polyol et formation des esters partiels acides de l'acide carboxylique polybasique puis en faisant réagir une partie des groupes carboxyle libres du produit de réaction ainsi obtenu avec un di- ou poly-époxyde, avec allongement des chaînes et le cas échéant ramification du produit ;

b) 1 à 35 % en poids d'au moins un polymère filmogène, soluble ou au moins dispersable dans l'eau ou dans les solutions aqueuses alcalines, compatible avec les oligomères du composant a), ayant un poids moléculaire moyen (moyenne en poids) supérieur à 15 000 environ ;

c) 1 à 30 % en poids d'au moins un monomère photopolymérisable compatible avec les oligomères du composant a) et les polymères du composant b) ;

d) 0,001 à 10 % en poids d'au moins un inducteur de photopolymérisation, et

e) 0 à 30 % en poids d'autres additifs et/ou produits auxiliaires, les indications de pourcentage données se rapportant dans chaque cas au mélange total.

12. Procédé selon la revendication 11, caractérisé en ce que l'on applique sur le support par laminage ou selon le cas par doublage une couche de réserve photopolymérisable formée au préalable par utilisation d'un film formant réserve pour application à sec selon l'une des revendications 1 à 10, en retirant de la couche de réserve photopolymérisable, avant l'application par laminage ou selon le cas par doublage, une feuille de couverture éventuellement présente, puis, après l'application par laminage ou selon le cas par doublage de la couche de réserve photopolymérisable sur le support, on retire de la couche de réserve — au choix avant ou après l'exposition à la lumière formant une image —, le support temporaire.